# EUROPÄISCHE PATENTSCHRIFT

(11) **EP 0 530 897 B1**
(45) Veröffentlichungstag und Bekanntmachung des Hinweises auf die Patenterteilung: **18.12.1996**
(21) Anmeldenummer: 92202584.6
(22) Anmeldetag: 25.08.1992
(51) Int. Cl.: C23C 18/12, H01L 21/316

(54) **Verfahren zur Herstellung ferroelektrischer Wismuttitanat-Schichten auf einem Substrat**
Process for depositing a ferro-electric Bismuth Titanate layer on a substrate
Procédé de dépôt d'une couche ferro électrique de titanate de Bismuth sur un substrat

(30) Priorität: 28.08.1991 DE 4128461
(43) Veröffentlichungstag der Anmeldung: 10.03.1993
(73) Patentinhaber: Philips Patentverwaltung GmbH, 22335 Hamburg (DE); Philips Electronics N.V., 5621 BA Eindhoven (NL)
(72) Erfinder: Klee, Mareike, Dr., W-2000 Hamburg 1 (DE); Brand, Wolfgang, W-2000 Hamburg 1 (DE); van Hal, Henricus Albertsu Maria, W-2000 Hamburg 1 (DE)
(74) Vertreter: Volmer, Georg, Dipl.-Ing.

(56) Entgegenhaltungen:
- DATABASE WPI Week 7403, Derwent Publications Ltd., London, GB; AN 74-04582V 'bismuth titanate thin films - for film capacitors' & JP-A-48 009 997 (NIPPON ELECTRIC CO) 8. Februar 1973

## Beschreibung

Die Erfindung betrifft ein Verfahren zur Herstellung von ferroelektrischen Schichten aus Wismuttitanat Bi₄Ti₃O₁₂ auf einem Substrat.

Dünne ferroelektrische Schichten sind für eine Vielzahl von elektrischen und optischen Anwendungen von Bedeutung wie z.B. für die Herstellung von Speichern, Displays oder Kondensatoren.

Bekannt für derartige Schichten sind ferroelektrische Verbindungen mit Perowskitstruktur. Für ferroelektrische Speicher werden z.B. bleihaltige Perowskitmaterialien eingesetzt. Diese haben bei ihrer Herstellung jedoch den Nachteil, daß durch Verdampfung von Bleioxid, besonders bei hohen Temperaturen, eine Kontrolle der Zusammensetzung häufig sehr schwierig ist. Bleihaltige Perowskite, wie z.B. PbTi_{0,5}Zr_{0,5}O₃ zeigen einen hohen Wert für die Dielektrizitätskonstante mit Werten für ε von etwa 1500. Materialien mit einer hohen Dielektrizitätskonstanten sind jedoch für ferroelektrische Speicheranwendungen nur bedingt einsetzbar.

Ein ferroelektrisches Materialsystem, das weder bei der Herstellung Probleme mit einer Bleiverdampfung zeigt und sich darüberhinaus durch eine relativ niedrige Dielektrizitätskonstante (ε < 150) auszeichnet, ist Wismuttitanat Bi₄Ti₃O₁₂. Dieses Material zeichnet sich darüberhinaus dadurch aus, daß beim Schalten des ferroelektrischen Materials entlang der c-Achse der Polarisationsvektor nur um einen Winkel von 9° gedreht wird.

Dünne Wismuttitanat-Schichten wurden bisher hergestellt mit Hilfe von Hochfreguenz-Kathodenzerstäubungsverfahren, wobei MgO-Substrate eingesetzt wurden. Kathodenzerstäubungsverfahren haben jedoch den Nachteil, daß eine genaue Kontrolle der Stöchiometrie der Schichtzusammensetzung in einem mehrkomponentigen System sehr schwierig ist. Weiterhin sind diese Verfahren experimentell sehr aufwendig, da sie unter Hochvakuum durchgeführt werden müssen.
Bei der Abscheidung mehrkomponentiger Systeme ist weiterhin eine sehr genaue Prozeßkontrolle notwendig. Ein zusätzlicher Nachteil von Kathodenzerstäubungsverfahren ist, daß diese Verfahren für kontinuierliche Produktionsprozesse ungeeignet sind. Die mittels Kathodenzerstäubungsverfahren hergestellten bekannten Schichten wurden in einer Dicke von 12 bis 32 µm realisiert. Derartige Schichtdicken sind für die Anwendung ferroelektrischer Schichten als Speicher jedoch ungeeignet.

Der Erfindung liegt die Aufgabe zugrunde, ein Verfahren der eingangs genannten Art zu schaffen, mit dem dünne ferroelektrische Wismuttitanat-Schichten reproduzierbar genau hinsichtlich ihrer Stöchiometrie und mit relativ geringem fertigungstechnischem Aufwand in einem kontinuierlichen Produktionsprozeß hergestellt werden können.

Diese Aufgabe wird erfindungsgemäß dadurch gelöst, daß eine Lösung, die in Form einer metallorganischen oder anorganischen Verbindung eingeführtes Wismut und Titan homogen vermischt in einem organischen Lösungsmittelgemisch in stöchiometrischem Verhältnis enthält, mit dem Substrat in Kontakt gebracht und unter Bildung von Wismuttitanat Bi₄Ti₃O₁₂ thermisch behandelt wird bei einer Temperatur im Bereich von 500 bis 650°C.

Vorteilhafte weitere Ausgestaltungen des erfindungsgemäßen Verfahren ergeben sich aus den Unteransprüchen.

Die mit der Erfindung erzielten Vorteile bestehen insbesondere darin, daß das vorliegende Verfahren kein Vakuumverfahren ist und deshalb Schichten sehr kostengünstig hergestellt werden können.

Da erfindungsgemäß die Abscheidung der dünnen Schichten aus Lösungen erfolgt, ist eine genaue Kontrollmöglichkeit der Zusammensetzung der Schichten gewährleistet. Die Zugabe von Dotierungen zur Verbesserung des elektrischen Verhaltens ist mit dem vorliegenden Verfahren leicht zu realisieren. Weiterhin ist das vorliegende chemische Beschichtungsverfahren für kontinuierliche Produktionsprozesse geeignet. Mit dem vorliegenden Verfahren ist es möglich, sehr dünne Wismuttitanat-Schichten einer Dicke von etwa 0,1 bis 2 µm bei relativ niedrigen Reaktionstemperaturen im Bereich von 500 bis 650°C herzustellen. Ein besonderer Vorteil liegt bei den relativ niedrigen Reaktionstemperaturen des vorliegenden Verfahrens. Höhere Reaktionstemperaturen sind einmal aus energietechnischen Gründen unerwünscht, sie führen aber auch dazu, daß mit zunehmender Reaktionstemperatur eine Reaktion der Schicht mit dem Substrat zu erwarten ist, was zur Bildung von Zweitphasen führen kann, die die elektrischen Eigenschaften der Schichten, wie z.B. Polarisationsverhalten, Schaltzeit, Alterungsverhalten, nachteilig beeinflussen.

Im folgenden werden Ausführungsbeispiele der Erfindung beschrieben und die Erfindung wird in ihrer Wirkungsweise erläutert.

### Beispiel 1

10 g Bi(NO₃)₃.5H₂O werden in einer Lösung aus 12,5 ml Methoxyethanol und 9,9 ml Glycerin gelöst. Zu dieser Lösung werden 5,25 g Titan-tetra-butylat zugefügt. Die so erhaltene Lösung wird zur Entfernung von Staubpartikeln und ungelösten Kristalliten durch ein Filter aus Zelluloseacetat mit einer Porenweite von 0,2 µm filtriert und anschließend unter Reinraumbedingungen (Staubklasse 100) auf ein in (100)-Richtung orientiertes Silicium-Einkristallsubstrat aufgebracht, auf das zunächst eine 0,5 µm dicke SiO₂-Schicht als Isolierschicht, eine 10 nm dicke Titan- und eine 33 nm dicke Platinschicht als untere Elektrodenschicht aufgebracht wurden. Aus der Lösung wird eine dünne Schicht durch Aufschleudern der Lösung bei 3000 U/min hergestellt. Diese Schicht wird mit einer Geschwindigkeit von 250 K/h auf eine Temperatur von 500°C aufgeheizt, über eine Dauer von 60 min bei dieser Temperatur getempert und mit einer Geschwindigkeit von 250 K/h auf Raumtemperatur abgekühlt. Der Beschichtungs- und Aufheizprozeß wird fünfmal wiederholt.

Röntgenbeugungsuntersuchungen haben gezeigt, daß die hergestellte dünne Schicht in der Wismuttitanatphase Bi₄Ti₃O₁₂ kristallisiert. Für elektrische Kontrolluntersuchungen wird die dünne Wismuttitanat-Schicht mit einer oberen Elektrode in Form einer dünnen Goldschicht bedampft. Kapazitäts- und Hysteresemessungen an kleinen, auf diese Weise hergestellten Kondensatoren zeigen, daß die erhaltene Wismuttitanat-Schicht ferroelektrisch ist.

### Beispiel 2

Als Ausgangsstoffe werden Wismutoktoat, gelöst in Testbenzin (Siedepunkt 100 bis 190°C) mit einem Wismutgehalt von 20,15 Gew.% und Titan-tetra-butylat mit einem Titangehalt von 14,09 Gew.% eingesetzt. 4,7878 g des Wismutausgangsstoffes und 1,177 g des Titanausgangsstoffes werden in 5 ml Butanol gelöst.

Die erhaltene Lösung wird unter Reinraumbedingungen (Staubklasse 100) auf ein in (100)-Richtung orientiertes Silicium-Einkristallsubstrat aufgebracht, auf welches zunächst eine 0,5 µm dicke SiO₂-Schicht als Isolierschicht, eine 10 nm dicke Titan- und eine 33 nm dicke Platin-Schicht als untere Elektrodenschicht aufgebracht wurden. Durch Aufschleudern der Lösung bei 3000 U/min wird eine dünne Schicht hergestellt. Die Schicht wird mit einer Geschwindigkeit von 250 K/h auf eine Temperatur von 500°C aufgeheizt, über eine Dauer von 60 min bei dieser Temperatur getempert und mit einer Geschwindigkeit von 250 K/h auf Raumtemperatur abgekühlt. Der Beschichtungs- und Aufheizprozeß wird fünfmal wiederholt.

Röntgenbeugungsuntersuchungen haben gezeigt, daß die hergestellte dünne Schicht in der Wismuttitanat-Phase Bi₄Ti₃O₁₂ kristallisiert.

### Beispiel 3

Die gleichen Ausgangsstoffe in gleicher Menge wie gemäß Beispiel 2 werden in einem Gemisch aus 5 ml Butanol und 1 ml N,N-Dimethylformamid gelöst. Die erhaltene Lösung wird unter Reinraumbedingungen (Staubklasse 100) auf ein in (100)-Richtung orientiertes Silicium-Einkristallsubstrat aufgebracht, auf das zunächst eine 0,5 µm dicke SiO₂Schicht als Isolierschicht, eine 10 nm dicke Titan- und eine 33 nm dicke Platin-Schicht als untere Elektrodenschicht aufgebracht wurden.

Aus der Lösung wird eine dünne Schicht durch Aufschleudern der Lösung bei 3000 U/min hergestellt. Diese Schicht wird mit einer Geschwindigkeit von 250 K/h auf eine Temperatur von 500°C aufgeheizt, über eine Dauer von 60 min bei dieser Temperatur getempert und mit einer Geschwindigkeit von 250 K/h auf Raumtemperatur abgekühlt. Der Beschichtungs- und Aufheizprozeß wird fünfmal wiederholt.

Röntgenbeugungsuntersuchungen haben gezeigt, daß die hergestellte dünne sehr homogene Schicht in der Wismuttitanat-Phase Bi₄Ti₃O₁₂ kristallisiert.

## Patentansprüche

1. Verfahren zur Herstellung von ferroelektrischen Schichten aus Wismuttitanat Bi₄Ti₃O₁₂ auf einem Substrat, dadurch gekennzeichnet,
daß eine Lösung, die in Form einer metallorganischen oder anorganischen Verbindung eingeführtes Wismut und Titan homogen vermischt in einem organischen Lösungsmittelgemisch in stöchiometrischem Verhältnis enthält, mit dem Substrat in Kontakt gebracht und unter Bildung von Wismuttitanat Bi₄Ti₃O₁₂ thermisch behandelt wird bei einer Temperatur im Bereich von 500 bis 650°C.

2. Verfahren nach Anspruch 1,
dadurch gekennzeichnet,
daß die thermische Behandlung zur Bildung von Wismuttitanat Bi₄Ti₃O₁₂ durchgeführt wird mit den Stufen
- Aufheizen mit einer Geschwindigkeit von 250 K/h auf die gewünschte Temperatur,
- Tempern über eine Dauer von etwa 60 min,
- Abkühlen mit einer Geschwindigkeit von 250 K/h auf Raumtemperatur.

3. Verfahren nach den Ansprüchen 1 und 2,
dadurch gekennzeichnet,
daß als Titanverbindung ein Titan-Alkoxid oder ein Titan-beta-diketonat eingesetzt wird.

4. Verfahren nach den Ansprüchen 1 und 2,
dadurch gekennzeichnet,
daß als Wismutverbindung ein Salz einer organischen oder anorganischen Säure eingesetzt wird.

5. Verfahren nach den Ansprüchen 1,2 und 4,
dadurch gekennzeichnet,
daß Wismut in Form von Bi(NO₃)₃.5H₂O in die Lösung eingeführt wird.

6. Verfahren nach den Ansprüchen 1,2 und 4,dadurch gekennzeichnet,
daß Wismut in Form von Wismutoktoat in die Lösung eingeführt wird.

7. Verfahren nach den Ansprüchen 1 bis 3,
dadurch gekennzeichnet,
daß Titan in Form von Titan-tetra-butylat in die Lösung eingeführt wird.

8. Verfahren nach den Ansprüchen 1,2,5 und 7,
dadurch gekennzeichnet,
daß als Lösungsmittel Methoxyethanol und Glycerin eingesetzt werden.

9. Verfahren nach den Ansprüchen 1,2,6 und 7,
dadurch gekennzeichnet,
daß als Lösungsmittel Testbenzin (Siedepunkt 100 bis 190°C) und Butanol oder Testbenzin (Siedepunkt 100 bis 190°C), Butanol und N,N-Dimethylformamid eingesetzt werden.

10. Verfahren nach den Ansprüchen 1 bis 9,
dadurch gekennzeichnet,
daß die Lösung durch Aufschleudern oder Tauchen auf das Substrat aufgebracht wird und daß der Beschichtungs- und der Aufheizprozeß wiederholt werden, bis die gewünschte Schichtdicke erreicht ist.

11. Verfahren nach den Ansprüchen 1 bis 10,dadurch gekennzeichnet,
daß als Substrat Silicium-Einkristallscheiben oder Scheiben aus Oxidkeramik eingesetzt werden.

## Claims

1. A method of manufacturing ferroelectric layers of bismuth-titanate Bi₄Ti₃O₁₂ on a substrate, characterized in that a solution containing bismuth and titanium, in a stoichiometric ratio, in the form of a metallo-organic or inorganic compound which is homogeneously mixed in an organic solvent mixture, is brought into contact with the substrate and thermally treated at a temperature in the range from 500° C to 650° C, thereby forming bismuth-titanate Bi₄Ti₃O₁₂.

2. A method as claimed in Claim 1, characterized in that the thermal treatment carried out to form bismuth titanate Bi₄Ti₃O₁₂ comprises the following steps:
- heating at a rate of 250 K/h to the desired temperature,
- tempering for approximately 60 minutes,
- cooling at a rate of 250 K/h to room temperature.

3. A method as claimed in Claims 1 and 2, characterized in that a titanium alkoxide or a titanium betadiketonate is used as the titanium compound.

4. A method as claimed in Claims 1 and 2, characterized in that a salt of an organic or inorganic acid is used as the bismuth compound.

5. A method as claimed in Claims 1, 2 and 4, characterized in that bismuth in the form of Bi(NO₃)₃.5H₂O is introduced into the solution.

6. A method as claimed in Claims 1, 2 and 4, characterized in that bismuth in the form of bismuthoctoate is introduced into the solution.

7. A method as claimed in Claim 1 to 3, characterized in that titanium in the form of titanium tetrabutylate is introduced into the solution.

8. A method as claimed in Claims 1, 2, 5 and 7, characterized in that methoxyethanol and glycerine are used as the solvents.

9. A method as claimed in Claims 1, 2, 6 and 7, characterized in that mineral varnish (boiling point 100° C to 190° C) and butanol or mineral varnish (boiling point 100° C to 190° C), butanol and N,N-dimethylformamide are used as the solvents.

10. A method as claimed in Claims 1 to 9, characterized in that the solution is provided on the substrate by spin coating or dip coating, and in that the coating and heating processes are repeated until the desired layer thickness is attained.

11. A method as claimed in Claims 1 to 10, characterized in that silicon single-crystal discs or discs of oxide ceramics are used as the substrate.

## Revendications

1. Procédé de dépôt sur un substrat de couches ferroélectriques de titanate de bismuth Bi₄Ti₃O₁₂, caractérisé en ce qu'une solution qui contient dans un rapport stoechiométrique du titane et du bismuth introduits sous la forme d'un composé inorganique ou organique métallique, mélangés de manière homogène dans un mélange de solvants organiques est mise en contact avec le substrat et traitée thermiquement à une température de l'ordre de 500 à 650°C pour former du titanate de bismuth Bi₄Ti₃O₁₂.

2. Procédé selon la revendication 1, caractérisé en ce que le traitement thermique pour la formation de titanate de bismuth Bi₄Ti₃O₁₂ comporte les étapes suivantes :
- chauffage à une vitesse de 250 K/h jusqu'à la température souhaitée;
- trempage pendant une durée d'environ 60 min;
- refroidissement à une vitesse de 250 K/h jusqu'à température ambiante.

3. Procédé selon l'une des revendications 1 et 2, caractérisé en ce qu'un alcoxyde de titane ou un bêta-dicétonate de titane sont utilisés comme composé de titane.

4. Procédé selon l'une des revendications 1 et 2, caractérisé en ce que le composé de bismuth utilisé est un sel d'un acide organique ou inorganique.

5. Procédé selon l'une des revendications 1, 2 et 4, caractérisé en ce que le bismuth est introduit dans la solution sous la forme de Bi(NO₃)₃.5H₂O.

6. Procédé selon l'une des revendications 1, 2 et 4, caractérisé en ce que le bismuth est introduit dans la solution sous la forme d'octoate de bismuth.

7. Procédé selon l'une des revendications 1 à 3, caractérisé en ce que le titane est introduit dans la solution sous la forme de tétrabutylate de titane.

8. Procédé selon l'une des revendications 1, 2, 5 et 7, caractérisé en ce que du méthoxyéthanol et de la glycérine sont utilisés comme solvants.

9. Procédé selon l'une des revendications 1, 2, 6 et 7, caractérisé en ce que du white-spirit (point d'ébullition 100 à 190°C) et du butanol ou du white-spirit (point d'ébullition 100 à 190°C), du butanol et du N,N-diméthylformamide sont utilisés comme solvants.

10. Procédé selon l'une des revendications 1 à 9, caractérisé en ce que la solution est appliquée par projection ou immersion sur le substrat et que l'opération de revêtement et de chauffage est répétée jusqu'à ce que l'épaisseur souhaitée de la couche soit atteinte.

11. Procédé selon l'une des revendications 1 à 10, caractérisé en ce que des tranches monocristallines de silicium ou des tranches de céramique d'oxyde sont utilisées comme substrat.
